# EUROPEAN PATENT APPLICATION

(11) **EP 4 383 313 A1**
(43) Date of publication of application: **12.06.2024**
(21) Application number: 23214725.6
(22) Date of filing: 06.12.2023
(51) Int. Cl.: H01L 21/28, H01L 29/51, H01L 21/02, H01L 29/66, H01L 29/78

(54) **ELECTRONIC DEVICE INCLUDING FERROELECTRIC THIN FILM, METHOD OF MANUFACTURING THE ELECTRONIC DEVICE, AND ELECTRONIC APPARATUS INCLUDING THE ELECTRONIC DEVICE**

(30) Priority: 07.12.2022 KR 20220170046
(71) Applicant: Samsung Electronics Co., Ltd., Suwon-si, Gyeonggi-do 16677 (KR)
(72) Inventor: LEE, Yunseong, 16678 Suwon-si (KR); HEO, Jinseong, 16678 Suwon-si (KR); KIM, Kihong, 16678 Suwon-si (KR); CHOE, Dukhyun, 16678 Suwon-si (KR); LEE, Hyunjae, 16678 Suwon-si (KR); JO, Sanghyun, 16678 Suwon-si (KR)
(74) Representative: Elkington and Fife LLP

(57) **Abstract**

An electronic device (10) may include a conductive material layer (11, 11a), a ferroelectric layer (30) covering the conductive material layer, and an electrode (50, 50a) covering the ferroelectric layer. The ferroelectric layer may include a compound represented by HfₓA_{y}O_{z}, where 0 ≤ x ≤ 1, 0 ≤ y ≤ 1, and 2(x+y) < z.

## Description

### FIELD OF THE INVENTION

The disclosure relates to an electronic device including a ferroelectric thin film, a method of manufacturing the ferroelectric thin film, and an electronic apparatus including the ferroelectric thin film.

### BACKGROUND OF THE INVENTION

According to a trend of increasing the integration density of electronic devices, such as memories or logic circuits, electronic devices in electronic apparatuses have become more refined. Accordingly, there may be increasing demand for refinement and low power consumption of electronic devices, such as transistors and capacitors. However, because the capacitance of an electronic device may be proportional to its area, the capacitance may decrease as the size of the electronic device decreases, and a leakage current may increase when the thickness of a dielectric is reduced to increase the capacitance. Accordingly, dielectric materials having a high dielectric constant (high-K) are increasingly being used in electronic devices.

Recently, in order to overcome power scaling limitations of devices in the art having high dielectric constants, new low-power devices using negative capacitance characteristics of ferroelectric materials have been proposed. In order to implement such a low-power device, it may be necessary to secure electrical characteristics and reliability of a ferroelectric thin film.

### SUMMARY OF THE INVENTION

Provided are an electronic device including a ferroelectric thin film having electrical characteristics and reliability, a method of manufacturing the electronic device, and an electronic apparatus including the electronic device.

Additional aspects will be set forth in part in the description which follows and, in part, will be apparent from the description, or may be learned by practice of the presented embodiments of the disclosure.

According to an embodiment, an electronic device may include a conductive material layer, a ferroelectric layer covering the conductive material layer, the ferroelectric layer including a compound represented by HfₓA_{y}O_{z}, where 0 ≤ x ≤ 1, 0 ≤ y ≤ 1, and 2(x+y) < z, and an electrode layer covering the ferroelectric layer.

In some embodiments, in the compound represented by HfₓA_{y}O_{z}, component A may include at least one of Al, Si, Zr, Y, La, Gd, Sr, and Mg.

In some embodiments, A may be Zr so the compound represented by HfₓA_{y}O_{z}, may include a compound represented by HfₓZr_{y}O₂₊ₐ, where 2(x+y) < 2+a and 0 < a < 1.

In some embodiments, the ferroelectric layer may further include carbon, and the carbon content may be less than 33 at% with respect to an amount of Hf in the ferroelectric layer.

In some embodiments, the ferroelectric layer may further include carbon, and the carbon content may be less than 10 at% with respect to an amount of Hf in the ferroelectric layer.

In some embodiments, the ferroelectric layer may further include carbon, and the carbon content may be less than 6 at% with respect to a sum of amounts of Hf, A, and oxygen in the ferroelectric layer.

In some embodiments, the ferroelectric layer may have a thickness of about 0.1 nm to about 20 nm.

In some embodiments, the ferroelectric layer may be formed such that 2Pr is 10 µC/cm² or greater.

In some embodiments, the ferroelectric layer may have a dielectric constant in the range of 15 to 25.

In some embodiments, the electronic device may further include a ferroelectric perovskite layer between the conductive material layer and the ferroelectric layer, and/or between the ferroelectric layer and the electrode layer.

In some embodiments, the electronic device may further include a dielectric layer between the conductive material layer and the ferroelectric layer, and/or between the ferroelectric layer and the electrode layer.

In some embodiments, the conductive material layer may include a channel, and the electrode layer may include a gate electrode.

In some embodiments, the electronic device may further include a substrate, and the channel may be spaced apart from an upper surface of the substrate and may extend in a first direction or the channel may include a plurality of channel elements spaced apart from each other in a second direction. The second direction may be different from the first direction.

In some embodiments, the ferroelectric layer may include a plurality of ferroelectric layers surrounding the plurality of channel elements, respectively, and the gate electrode may protrude from the upper surface of the substrate to surround the plurality of ferroelectric layers.

In some embodiments, the gate electrode may be one of a plurality of gate electrodes in a stack structure. The stack structure may include the plurality of gate electrodes alternatively stacked with a plurality of insulating layers in a vertical direction. The stack structure may include a plurality of channel holes penetrating the stack structure in the vertical direction. The ferroelectric layer and the conductive material layer may be concentrically arranged inside the plurality of channel holes to form a memory cell string in which a plurality of memory cell strings are two-dimensionally arranged.

According to an embodiment, a semiconductor device may include a conductive material layer forming a channel, a ferroelectric layer covering the conductive material layer, a gate electrode covering the ferroelectric layer, and a source region and a drain region electrically connected to both ends of the channel. The ferroelectric layer may include a compound represented by HfₓA_{y}O_{z}, where 0 ≤ x ≤ 1, 0 ≤ y ≤ 1, and 2(x+y) < z.

According to an embodiment, a method of manufacturing a ferroelectric thin film may include forming a material layer comprising Hf, A, and O on a base layer; and crystallizing the material layer by performing heat treatment on the material layer in a vacuum environment to provide a crystallized ferroelectric layer, the crystallized ferroelectric layer comprising a compound represented by HfₓA_{y}O_{z}( where 0 ≤ x ≤ 1, 0 ≤ y ≤ 1) and having an oxygen content of 2(x+y) < z.

In some embodiments, the method may further include forming an electrode layer on the material layer or the ferroelectric layer, and the heat treatment may be performed before and/or after the forming the electrode layer.

In some embodiments, the heat treatment may be performed at a temperature of at least 200 °C but less than 500 °C and/or in a vacuum environment with a pressure ranging from 1E-7 Torr to 9E-4 Torr.

In some embodiments, the heat treatment may be performed at a temperature of 200 °C to 350 °C.

In some embodiments, the heat treatment may be performed in a chamber in which the material layer is formed.

### BRIEF DESCRIPTION OF THE DRAWINGS

The above and other aspects, features, and advantages of certain embodiments of the disclosure will be more apparent from the following description taken in conjunction with the accompanying drawings, in which:
FIGS. 1 to 5 are cross-sectional views schematically illustrating electronic devices according to embodiments;
FIG. 6 shows a change in a ferroelectric layer of a sample of an electronic device before and after heat treatment in a vacuum environment, according to an embodiment;
FIG. 7 shows a comparison between a material layer before heat treatment and a ferroelectric layer after the heat treatment, according to a comparative example and an embodiment;
FIGS. 8 and 9 show results of X-ray diffraction analysis and X-ray photoelectron spectroscopy (XPS) elemental analysis of samples of respective heat treatment methods;
FIG. 10 shows ferroelectric (P-V) properties of samples of respective heat treatment methods;
FIG. 11 shows leakage current (I-V) characteristics of samples of respective heat treatment methods;
FIGS. 12 and 13 show capacitance-voltage characteristics and endurance characteristics of samples of respective heat treatment methods;
FIG. 14 illustrates an example in which an electronic device is formed as a three-dimensional structure including a fin channel, according to an embodiment;
FIG. 15 illustrates an example in which an electronic device is formed as a three-dimensional structure in which a gate electrode surrounds a channel in all directions, according to an embodiment;
FIG. 16 is a cross-sectional view schematically illustrating a gate structure of the electronic device illustrated in FIG. 15;
FIG. 17 is a schematic circuit diagram of a memory device including an electronic device array;
FIG. 18 is a perspective view illustrating an electronic device according to an embodiment;
FIG. 19 is an enlarged cross-sectional view of portion A of FIG. 18;
FIGS. 20 to 23 are cross-sectional views schematically illustrating electronic devices according to embodiments;
FIG. 24 schematically illustrates an example of applying an electronic device according to an embodiment;
FIG. 25 is a schematic block diagram of a display driver integrated circuit (IC) and a display apparatus including the display driver IC, according to an embodiment;
FIGS. 26 and 27 are block diagrams illustrating electronic apparatuses according to embodiments;
FIGS. 28 and 29 are conceptual diagrams schematically illustrating a device architecture that may be applied to an electronic apparatus, according to an embodiment; and
FIG. 30 is a flow chart illustrating operations of a method of manufacturing an electronic device according to example embodiments.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Hereinafter, embodiments will be described in detail with reference to the accompanying drawings. In the following drawings, like reference numerals refer to like elements, and sizes of elements in the drawings may be exaggerated for clarity and convenience of description. Embodiments described below are merely examples, and various modifications are possible from these embodiments.

In the following descriptions, when an element is referred to as being "on" or "above" another element, the element may directly contact a top/bottom/left/right portion of the other element, or may be on/under/next to the other element with intervening elements therebetween. Singular forms are intended to include plural forms as well, unless the context clearly indicates otherwise. In addition, when an element is referred to as "including" a component, the element may additionally include other components rather than excluding other components as long as there is no particular opposing recitation.

The term "the" and other demonstratives similar thereto may include a singular form and plural forms. Operations of a method described herein may be performed in any suitable order unless otherwise indicated herein or otherwise clearly contradicted by context, and the disclosure is not limited to the described order of the operations.

In addition, as used herein, terms such as "...er (or)", "... unit","... module", etc., denote a unit that performs at least one function or operation, which may be implemented as hardware or software or a combination thereof.

Line connections or connection members between elements depicted in the drawings represent functional connections and/or physical or circuit connections by way of example, and in actual applications, they may be replaced or embodied with various suitable additional functional connections, physical connections, or circuit connections.

Ferroelectric materials have spontaneous polarization as the charge distribution is non-centrosymmetric in a crystallized material structure. The ferroelectric material has remnant polarization (Pr) due to a dipole even in an absence of an external electric field. In addition, the direction of polarization may be switched by an external electric field.

For example, a ferroelectric thin film such as HfₓZr₁₋ₓO₂ may be crystallized through an additional heat treatment after deposition of a material layer including Hf, Zr, and O so as to have ferroelectric properties. Here, when the heat treatment temperature is high, oxygen vacancies are formed, which has an effect of increasing ferroelectricity, but also causes reliability degradation. Depending on the heat treatment temperature, a large amount of defects or current leakage paths that may deteriorate the characteristics of the ferroelectric thin film may be activated, which may negatively affect the characteristics of a manufactured electronic device. In addition, the possibility of contamination cannot be ruled out when a wafer is exposed to the outside of a chamber for heat treatment, and when contamination occurs, the characteristics of the electronic device may be deteriorated. In addition, as the thickness of the ferroelectric thin film decreases, the heat treatment method becomes more complicated and the process difficulty increases, which may negatively affect the characteristics of the electronic device. Thus, it may be necessary to manufacture a ferroelectric thin film having electrical characteristics and reliability.

In addition, when manufacturing a ferroelectric thin film, some unreacted carbon may remain inside the thin film deposited with a metal precursor containing carbon, which acts as a defect in the ferroelectric thin film and deteriorates the electrical characteristics. In addition, the ferroelectric thin film has a certain amount of oxygen vacancies (Vo) therein.

As the amount of Vo included in the ferroelectric thin film, the ferroelectric thin film has a larger remnant polarization (Pr) and forms a larger amount of nucleation that may cause polarization switching, and thus may be advantageous in that switching may be performed even at a low voltage. However, because a lot of Vo included in the ferroelectric thin film acts as a defect that deteriorates the leakage characteristics and endurance characteristics of the ferroelectric thin film, it may be necessary to maintain an appropriate ratio of Vo to carbon inside the ferroelectric thin film.

According to an electronic device according to an embodiment, a ferroelectric layer may be heat-treated at a relatively low temperature in a vacuum environment to be converted into a crystal exhibiting ferroelectric properties, thus, the amounts of oxygen vacancies (Vo) inside the ferroelectric layer and carbon from ligands of a pyrolyzed precursor decrease, and accordingly, electrical characteristics may be improved and reliability may be secured.

As described above, according to methods of manufacturing an electronic device and a ferroelectric thin film according to an embodiment, crystallization may be performed to ensure sufficiently high ferroelectricity at a low heat treatment temperature, such that electrical characteristics and reliability required in an electronic device including a ferroelectric layer may be secured.

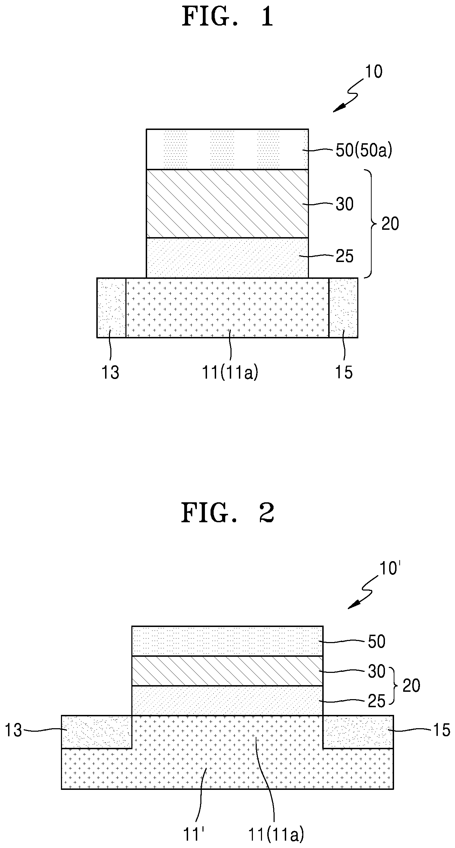

FIG. 1 is a cross-sectional view schematically illustrating an electronic device 10 according to an embodiment. FIG. 1 shows an example in which the electronic device 10 according to an embodiment is implemented as a logic transistor or a memory transistor.

Referring to FIG. 1, the electronic device 10 includes a channel 11 as a conductive material layer 11a, a gate insulating layer 20 including a ferroelectric layer 30 and covering the channel 11, and a gate electrode 50 as an electrode layer 50a on the gate insulating layer 20. In addition, the electronic device 10 according to an embodiment may include a first source/drain region 13 and a second source/drain region 15, which are electrically connected to both ends of the channel 11, respectively. One of the first source/drain region 13 and the second source/drain region 15 may be a source region S, and the other may be a drain region D.

The electronic device 10 according to an embodiment has negative capacitance (NC) and may be implemented as a memory device as a logic device having two or more threshold voltages.

The channel 11 may be formed as a substrate base or implemented as a separate material layer. For example, in a case in which the channel 11 is formed as a substrate base, the channel 11 may include semiconductor materials such as silicon (Si), germanium (Ge), silicon germanium (SiGe), silicon carbide (SiC), or a group III-V semiconductor material, for example, gallium arsenide (GaAs), indium arsenide (InAs), or indium phosphide (InP). In addition, in a case in which the channel 11 is not formed as a substrate base but is implemented as a separate material layer, the channel 11 may include Si, Ge, SiGe, SiC, a group III-V semiconductor material, an oxide semiconductor, a nitride semiconductor, an oxynitride semiconductor, a two-dimensional (2D) material, quantum dots, and/or an organic semiconductor. For example, the oxide semiconductor may include InGaZnO or the like. The 2D material may include transition metal dichalcogenide (TMD) or graphene. The TMD may include a compound of a transition metal and a chalcogen element. For example, the TMD may include MoS₂, MoSe₂, MoTe₂, WS₂, WSe₂, WTe₂, ZrS₂, ZrSe₂, HfS₂, HfSe₂, NbSe₂, ReSe₂, or the like. The quantum dots may include a colloidal quantum dot (QD) or a nanocrystal structure.

The first source/drain region 13 may be formed on one side of the channel 11 and the second source/drain region 15 may be formed on the other side of the channel 11. In a case in which the channel 11 is formed as a substrate base, the first source/drain region 13, the second source/drain region 15, and the channel 11 may be formed by injecting impurities into different regions of a semiconductor substrate, and may include a substrate material as a base material. For example, the channel 11 may be a Si channel. In a case in which the channel 11 is not formed as a substrate base but is implemented as a separate material layer, the first source/drain region 13 and the second source/drain region 15 may be formed of a conductive material. For example, the first source/drain region 13 and the second source/drain region 15 may include a metal, a metal compound, or a conductive polymer.

In the electronic device 10 according to an embodiment, the gate insulating layer 20 may include the ferroelectric layer 30.

The ferroelectric layer 30 forming the gate insulating layer 20 may be formed of oxygen-rich HfAO oxide and may be crystallized to exhibit ferroelectric properties. That is, the ferroelectric layer 30 may be formed of an oxide including HfₓA_{y}O_{z} (where 2(x+y) < z, 0 ≤ x ≤ 1, and 0 ≤ y ≤ 1). For example, the ferroelectric layer 30 may be formed of an oxide including HfₓA_{y}O_{z} (where 2(x+y) < z), where x may satisfy 0 <x ≤ 1 or 0 < x ≤ 0.7, and y may satisfy 0 ≤ y < 1 or 0.3 ≤ y < 1. For example, the ferroelectric layer 30 may be formed of an oxide including HfₓA_{y}O_{z} (where 2(x+y) < z), where z may be greater than 2 times the sum of x and y (i.e., x+y) and less than or equal to 2.3 times, 2.2 times, or 2.1 times the sum. The ferroelectric layer 30 may be formed of an oxide including, for example, HfₓA_{y}O₂ (where 2(x+y) < 2), and component A may be, for example, at least one selected from Zr, Si, Al, Y, La, Gd, Sr, and Mg. For example, component A may be added as a dopant. The ferroelectric layer 30 may be heat-treated at a relatively low temperature in a vacuum condition with a certain pressure or less to satisfy the condition of 2(x+y) < z (where 0 ≤ x ≤ 1 and 0 ≤ y ≤ 1), and may be crystallized to exhibit ferroelectric properties.

The ferroelectric layer 30 may include an orthorhombic crystal phase and/or a tetragonal crystal phase. In some cases, the ferroelectric layer 30 may include more orthorhombic crystal phases than tetragonal crystal phases. Such a crystal phase distribution may be identified by methods known in the art, and for example, transmission electron microscopy (TEM), grazing Incidence X-ray Diffraction (GIXRD), or the like may be used.

The ferroelectric layer 30 may be formed to include, for example, a dopant of component A within a material having a hafnia-based fluorite structure. Here, dopant A may be at least one selected from Zr, Si, Al, Y, La, Gd, Sr, and Mg.

A matrix material of the ferroelectric layer 30 is formed by atomic layer deposition through sequential injection cycles of a Hf precursor and an oxidant, and for injection of a dopant, sub-cycle (SC) doping for injecting and doping a dopant of component A may be added in a middle of the sequential injection cycles of the Hf precursor and the oxidant for forming the matrix material of the ferroelectric layer 30. Here, the sub-cycle doping may be performed after a Hf precursor injection cycle.

Accordingly, by adding the dopant sub-cycle doping of component A in the middle of the sequential injection cycles of the Hf precursor and the oxidant for forming the matrix material through atomic layer deposition and after the Hf precursor injection cycle, the matrix material may be doped with the dopant at a desired concentration, and the ferroelectric layer 30 including HfₓA_{y}O_{z} (where 0 ≤ x ≤ 1 and 0 ≤ y ≤ 1) oxide may be formed.

As another example, the ferroelectric layer 30 may be formed by alternately and repeatedly depositing, for example, hafnium oxide (HfO₂) and an oxide including component A. That is, the ferroelectric layer 30 may be formed by a solid solution deposition method. For example, hafnium oxide and an oxide including component A may be alternately deposited in one cycle or in a plurality of cycles. Hafnium oxide may be deposited by one cycle or a plurality of cycles of atomic layer deposition through sequential injection of a Hf precursor and an oxidant, and an oxide including component A may be deposited by one cycle or a plurality of cycles of atomic layer deposition through sequential injection of a precursor of component A and an oxidant. As such, the ferroelectric layer 30 including HfAO oxide may be formed by alternately depositing hafnium oxide and an oxide including component A in one cycle or in a plurality of cycles. Here, component A may be at least one selected from Zr, Si, Al, Y, La, Gd, Sr, and Mg. That is, the ferroelectric layer 30 may be formed of HfₓA_{y}O_{z} (HfAO), which is a doped hafnia ferroelectric thin film, by a solid solution deposition method in which hafnium oxide and a dopant oxide are alternately deposited.

For example, the ferroelectric layer 30 may be formed of an oxide including HfₓZr_{y}O_{z} (where 2(x+y) < z). In a case in which the ferroelectric layer 30 is formed of HfₓZr_{y}O_{z} by doping HfO₂ with a Zr dopant, a matrix material of HfO₂ may be formed by atomic layer deposition through sequential injection of a Hf precursor and an oxidant, and Zr dopant sub-cycle (SC) doping may be performed after Hf precursor injection and in a middle of sequential injection, and then oxidant injection may be performed. Accordingly, the ferroelectric layer 30 including HfₓZr_{y}O_{z} doped with Zr at a desired concentration may be formed. In addition, the ferroelectric layer 30 may be formed of HfₓZr_{y}O_{z} (HZO), which is a doped hafnia ferroelectric thin film, by a solid solution deposition method in which hafnium oxide and a Zr oxide are alternately deposited.

Meanwhile, the ferroelectric layer 30 may be formed to a thickness of, for example, about 0.1 nm to about 20 nm. In addition, the ferroelectric layer 30 may be formed to have ferroelectric properties such that 2Pr is 10 µC/cm² or greater. In addition, the ferroelectric layer 30 may be formed to have a dielectric constant within a range of approximately 15 to 25.

In order to form the ferroelectric layer 30 having such ferroelectric properties and dielectric constant, the ferroelectric layer 30 may be crystallized through heat treatment at a relatively low temperature in a relatively high vacuum condition. The heat treatment of the ferroelectric layer 30 may be performed, for example, under a vacuum pressure within a range of approximately 1E-7 Torr to 9E-4 Torr. Here, the heat treatment temperature of the ferroelectric layer 30 may be, for example, higher than or equal to about 200 °C and less than about 500 °C. The heat treatment temperature of the ferroelectric layer 30 may be, for example, within a temperature range between about 200 °C and about 350 °C. The ferroelectric layer 30 may be heat-treated at, for example, approximately 250 °C.

As such, when heat treatment is performed at a relatively low temperature under a relatively high vacuum condition, the ferroelectric layer 30 including HfₓA_{y}O_{z} may have an oxygen content that satisfies 2(x+y) < z (where 0 ≤ x ≤ 1 and 0 ≤ y ≤ 1). Here, component A may include at least one of Al, Si, Zr, Y, La, Gd, Sr, and Mg. For example, the ferroelectric layer 30 may include HfₓZr_{y}O₂₊ₐ and may be formed to have an oxygen content of 2(x+y) < 2+a. For example, the ferroelectric layer 30 may include HfₓZr_{y}O₂₊ₐ and may have an oxygen content of 2(x+y) < 2+a, and Hf and Zr may be in a ratio of 1:1, that is, x = y = 0.5. Here, 'a' may be greater than 0 and less than 1. For example, 'a' may be greater than 0 but less than or equal to 0.5, or may be greater than 0 but less than or equal to 0.3. As such, the ferroelectric layer 30 may be formed as an oxygen-excess thin film in a HfZrO ferroelectric thin film.

The ferroelectric layer 30 may be deposited by applying various thin-film deposition processes such as atomic layer deposition (ALD), chemical vapor deposition (CVD), or physical vapor deposition (PVD), and in the thin-film deposition process, a carbon-containing metal precursor, that is, an organic metal precursor may be applied. For example, in a process of depositing a thin film such as the ferroelectric layer 30, atomic layer deposition of a metal oxide may be performed by alternately exposing a carbon-containing metal precursor, that is, an organic metal precursor, and a counter reactant.

Here, in the electronic device 10 according to an embodiment, the ferroelectric layer 30 may be formed by forming a material layer with a composition of HfxAyOz (where 0≤ x ≤1, 0≤ y ≤1, 2(x+y) < z) through a thin-film deposition process such as ALD, and crystallizing the material layer to exhibit ferroelectric properties. Alternatively, the ferroelectric layer 30 may be formed by forming a material layer including Hf, A, and O through a thin-film deposition process such as ALD, and heat-treating the material layer at a low temperature in a vacuum environment to be crystallized to include a composition (or oxygen content) of HfₓA_{y}O₂ (where 0 ≤ x ≤ 1, 0 ≤ y ≤ 1, and 2(x+y) < z) and exhibit ferroelectric properties.. Here, the ferroelectric layer 30 may further include carbon.

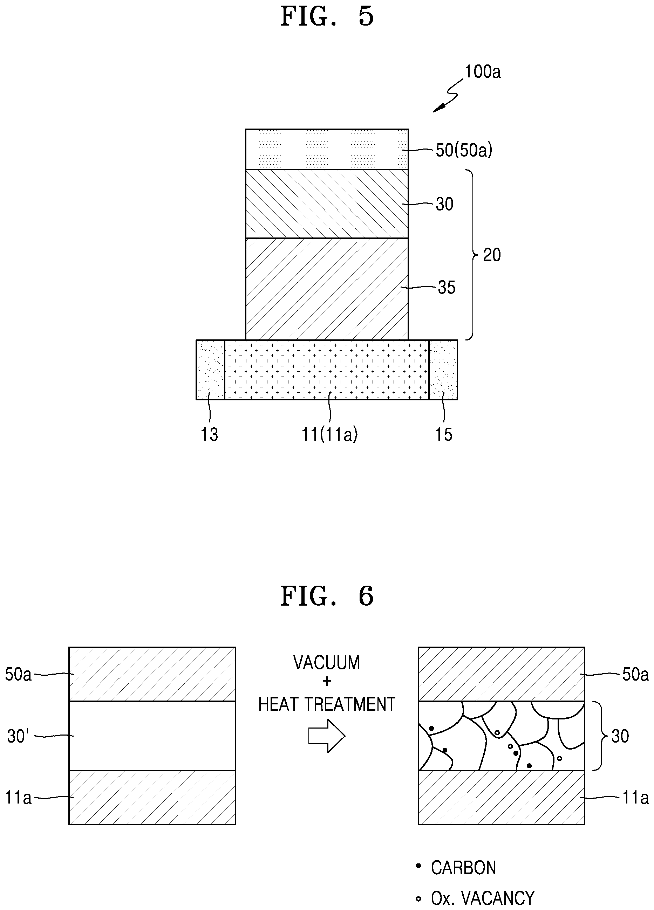

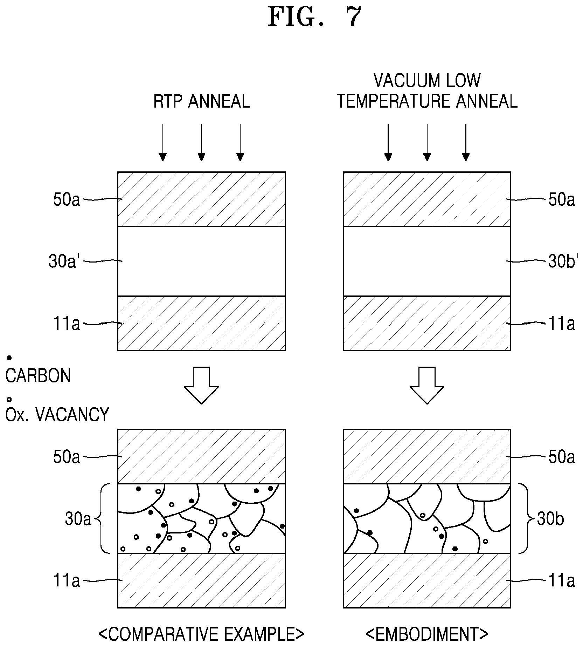

According to the ferroelectric layer 30 formed as described above, as will be described below with reference to FIGS. 6 and 7, oxygen vacancies (Vo) may be reduced and remaining carbon may also be reduced. Thus, the amounts of oxygen vacancies (Vo) formed inside the ferroelectric layer 30 and carbon formed from ligands of a pyrolyzed precursor are reduced, and thus, electrical characteristics may be improved and reliability may be secured.

Here, carbon may still be present in the ferroelectric layer 30 crystallized through the high-vacuum low-temperature heat treatment, in which case, the remaining carbon in the ferroelectric layer 30 may be less than 33 at%, for example, less than 10 at%, with respect to a Hf element. Compared to the sum of Hf, component A, and an oxygen component of the ferroelectric layer 30, the carbon in the ferroelectric layer 30 may be less than about 6 at%, for example, less than 3 at%. Meanwhile, the ferroelectric layer 30 may be formed to a thickness of about 0.1 nm to about 20 nm, for example, and may be formed to have ferroelectric properties such that 2Pr is 10 µC/cm² or greater. In addition, the ferroelectric layer 30 may be formed to have a dielectric constant within a range of approximately 15 to 25.

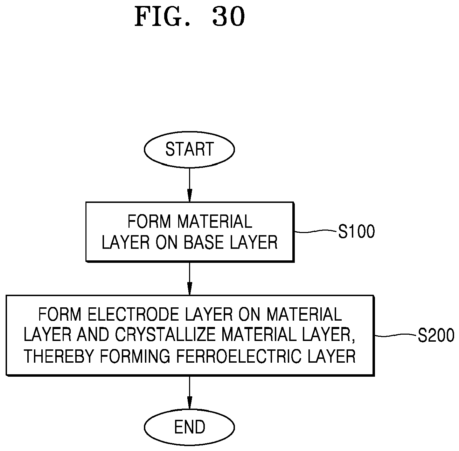

FIG. 30 is a flow chart illustrating operations of a method of manufacturing an electronic device according to example embodiment.

Referring to FIG. 30, the ferroelectric layer 30 may be formed through the following process of manufacturing a ferroelectric thin film. For example, first, a material layer 30' including Hf, A, and O may be formed on a base layer through a deposition process (S100). Here, component A may include at least one of Al, Si, Zr, Y, La, Gd, Sr, and Mg. The base layer is a layer including the conductive material layer 11a and may be, for example, a semiconductor structure including the channel 11. After the material layer 30' for forming the ferroelectric layer 30 is deposited on the base layer, the electrode layer 50a may be formed on the material layer 30' and the material layer 30' may be crystallized (S200). The ferroelectric layer 30 may be formed by heat-treating the material layer 30' at a low temperature in the vacuum environment described above to be crystallized. The heat treatment of the material layer 30' may be performed before forming the electrode layer 50a or after forming the electrode layer 50a on the material layer 30'. As another example, the heat treatment of the material layer 30' may be performed before and after forming the electrode layer 50a.

In addition, the heat treatment of the material layer 30' may be performed in situ, for example, in the same chamber as a chamber in which the deposition process of the material layer 30' is performed. As such, in a case in which the deposition process and the heat treatment process of the material layer 30' are performed in the same chamber, contamination due to a chamber change of the electronic device 10 including the ferroelectric layer 30 may be limited and/or prevented.

According to the method of manufacturing a ferroelectric thin film as described above, it is possible to improve electrical characteristics of a thin film by reducing the amount of Vo formed inside the thin film and the amount of carbon formed from ligands of a pyrolyzed precursor, thereby manufacturing a ferroelectric thin film having excellent reliability and electrical characteristics.

According to the method of manufacturing a ferroelectric thin film according to an embodiment, a material layer including Hf, A, and O may be formed on a base layer, and the material layer may be heat-treated at low temperature in a vacuum environment to be crystallized to form a ferroelectric layer including HfₓA_{y}O_{z} (where 0 ≤ x ≤ 1 and 0 ≤ y ≤ 1) and having an oxygen content of 2(x+y) < z. For example, the ferroelectric thin film may be formed to include HfₓZr_{y}O₂₊ₐ and have an oxygen content of 2(x+y) < 2+a. For example, the ferroelectric thin film may be formed to include HfₓZr_{y}O₂₊ₐ and have an oxygen content of 2(x+y) < 2+a, wherein the ratio of Hf and Zr may be 1:1, i.e., x = y = 0.5. Here, 'a' may be greater than 0 and less than 1. For example, 'a' may be greater than 0 but less than or equal to 0.5, or may be greater than 0 but less than or equal to 0.3. As such, an oxygen-excess HfZrO ferroelectric thin film may be formed.

Meanwhile, as described above, carbon may still be present in the ferroelectric thin film crystallized through the high-vacuum low-temperature heat treatment, in which case, the remaining carbon may be less than 33 at%, for example, less than 10 at%, with respect to a Hf element. Compared to the sum of Hf, component A, and an oxygen component of the ferroelectric thin film, the carbon remaining in the ferroelectric thin film may be less than about 6 at%, for example, less than 3 at%. In addition, the ferroelectric thin film may be formed, for example, to a thickness of about 0.1 nm to about 20 nm, to have ferroelectric properties such that 2Pr is 10 µC/cm² or greater, and to have a dielectric constant of about 15 to about 25.

According to a processing of manufacturing a ferroelectric thin film as described above, it is possible to improve electrical characteristics of the thin film by reducing the amount of Vo formed inside the thin film and the amount of carbon formed from ligands of a pyrolyzed precursor, thereby manufacturing a ferroelectric thin film having excellent reliability and electrical characteristics.

The electronic device 10 including the ferroelectric layer 30 formed through the process of manufacturing a ferroelectric thin film may have, for example, an advantage of having a high switching voltage while having a minimum remanent polarization (Pr) value required in a ferroelectric memory device, and may alleviate an electric-field concentration phenomenon that causes reliability degradation, as the difference with the dielectric constant of an interface layer below the ferroelectric layer 30 is reduced.

Meanwhile, in the electronic device 10 according to an embodiment, the ferroelectric layer 30 may be formed, for example, to a thickness of about 0.1 nm to about 20 nm. For example, when the electronic device 10 according to an embodiment is implemented as a logic device, the ferroelectric layer 30 may be formed to a thickness of about 0.1 nm to about 5 nm, about 0.1 nm to about 3 nm, or about 0.5 nm to about 3 nm. For example, when the electronic device 10 according to an embodiment is implemented as a memory device, the ferroelectric layer 30 may be formed to a thickness of about 1 nm to about 20 nm, about 3 nm to about 20 nm, about 5 nm to about 20 nm, or about 5 nm to about 10 nm.

Meanwhile, the electrode layer 50a, that is, the gate electrode 50, may include a metal, a metal nitride, a metal carbide, polysilicon, and/or a 2D conductive material. For example, the metal may include aluminum (Al), tungsten (W), molybdenum (Mo), titanium (Ti), and/or tantalum (Ta). The metal nitride may include titanium nitride (TiN) and/or tantalum nitride (TaN). The metal carbide may be a metal carbide doped with (or containing) aluminum and/or silicon, and as a specific example, may include TiAIC, TaAlC, TiSiC, or TaSiC. The gate electrode 50 may have a structure in which a plurality of materials are stacked, and for example, may have a stack structure of metal nitride layer/metal layer such as TiN/Al, or a stack structure of metal nitride layer/metal carbide layer/metal layer such as TiN/TiAlC/W.

Meanwhile, in the electronic device 10 according to an embodiment, the gate insulating layer 20 may further include a dielectric layer 25 between the channel 11 and the ferroelectric layer 30. The dielectric layer 25 may be formed of, for example, a dielectric material that is not ferroelectric. For example, the dielectric layer 25 may include an antiferroelectric or amorphous dielectric material. As another example, the dielectric layer 25 may be provided between the ferroelectric layer 30 and the gate electrode 50, or may be provided between the channel 11 and the ferroelectric layer 30 and between the ferroelectric layer 30 and the gate electrode 50, respectively.

The dielectric layer 25 may serve to stabilize negative capacitance of the ferroelectric layer 30. The dielectric layer 25 may include, for example, at least one of SiO, A1O, SiON, and SiN, and may have a single-layer or multi-layer structure.

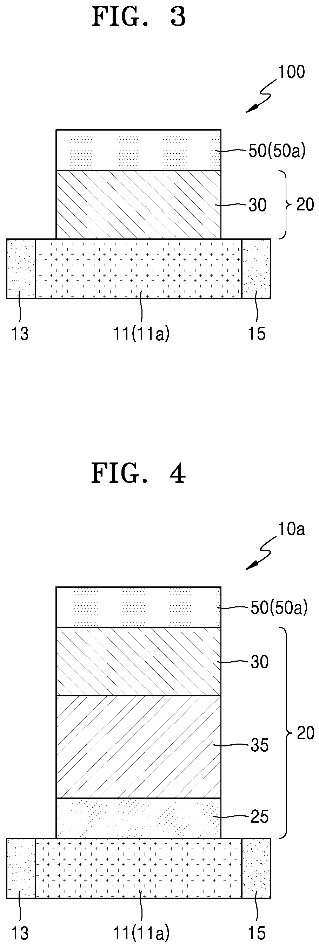

In a case in which the channel 11 includes Si or Ge, the dielectric layer 25 may be formed of, for example, a native oxide layer or an oxide layer other than the native oxide layer. As another example, even in a case in which the channel 11 includes Si or Ge, the native oxide layer may be removed, and as in an electronic device 100 as an example illustrated in FIG. 3 to be described below, the ferroelectric layer 30 may be formed directly on the channel 11.

FIG. 2 schematically illustrates an electronic device 10' according to an embodiment, and corresponds to an example in which the channel 11 in the electronic device 10 of FIG. 1 is formed by using a semiconductor substrate 11' as a base. As illustrated in FIG. 2, when the channel 11 is formed by using the semiconductor substrate 11' as a base, the first source/drain region 13, the second source/drain region 15, and the channel 11 may be formed by injecting impurities into different regions of the semiconductor substrate 11'.

FIG. 3 is a cross-sectional view schematically illustrating the electronic device 100 according to an embodiment, and the electronic device 100 is substantially the same as the electronic device 10 according to the embodiment of FIG. 1, except that the ferroelectric layer 30 is formed directly on the channel 11. As such, the electronic device 100 according to an embodiment may not include, for example, a dielectric layer (25 of FIG. 1) between the channel 11 and the ferroelectric layer 30.

Even in the electronic device 100 according to an embodiment, as described above, the channel 11 may be formed as a substrate base or implemented as a separate material layer. In addition, the channel 11 may include Si or Ge, and in this case, the ferroelectric layer 30 may be formed on the channel 11 after removing a native oxide layer formed on the channel 11.

In the electronic device 100 according to an embodiment, in a case in which the channel 11 is formed by using the semiconductor substrate 11' as a base, as in the electronic device 10' as an example illustrated in FIG. 2, the first source/drain region 13, the second source/drain region 15, and the channel 11 may be formed by injecting impurities into different regions of the semiconductor substrate 11'.

FIG. 4 is a cross-sectional view schematically illustrating an electronic device 10a according to an embodiment, and the electronic device 10a is substantially the same as the electronic device 10 according to the embodiment of FIG. 1, except that the electronic device 10a further includes a ferroelectric perovskite layer 35 between the dielectric layer 25 and the ferroelectric layer 30. FIG. 5 is a cross-sectional view schematically illustrating an electronic device 100a according to an embodiment, and the electronic device 100a is substantially the same as the electronic device 100 according to the embodiment of FIG. 3, except that the electronic device 100a further includes the ferroelectric perovskite layer 35 between the channel 11 and the ferroelectric layer 30. As illustrated in FIGS. 4 and 5, the gate insulating layer 20 may further include the perovskite layer 35.

The perovskite layer 35 may be formed to a thickness exhibiting ferroelectric properties. For example, the perovskite layer 35 may have a thickness greater than that of the ferroelectric layer 30. The perovskite layer 35 may have a thickness of, for example, tens to hundreds of nm, for example, about 100 nm.

Even in the electronic device 10a or 100a according to an embodiment, as described above, the channel 11 may be formed as a substrate base or implemented as a separate material layer. In addition, the channel 11 may include Si or Ge, and in this case, the gate insulating layer 20 may be formed on the channel 11 after removing a native oxide layer formed on the channel 11.

In the electronic device 10a or 100a according to an embodiment, in a case in which the channel 11 is formed by using the semiconductor substrate 11' as a base, as in the electronic device 10' as an example illustrated in FIG. 2, the first source/drain region 13, the second source/drain region 15, and the channel 11 may be formed by injecting impurities into different regions of the semiconductor substrate 11'.

FIG. 6 shows a change in a ferroelectric layer of a sample of an electronic device before and after heat treatment in a vacuum environment, according to an embodiment. FIG. 6 illustrates an example in which a sample of the embodiment has a stack structure of the conductive material layer 11a, the material layer 30' including Hf, A, and O, and the electrode layer 50a, and heat treatment is performed in a state in which the electrode layer 50a is formed on the material layer 30'. As another example, the heat treatment may be performed before forming the electrode layer 50a. In addition, the heat treatment may be performed before and after forming the electrode layer 50a, respectively.

In FIG. 6, the left side illustrates the material layer 30' before heat treatment, and the right side illustrates the ferroelectric layer 30 including HfₓA_{y}O_{z} (where 0 ≤ x ≤ 1 and 0 ≤ y ≤ 1) and having an oxygen content of 2(x+y) < z, after heat treatment in a vacuum environment. FIG. 6 as an example illustrates a sample heat-treated at about 250 °C in a vacuum environment of 9E-5 Torr.

As illustrated in FIG. 6, the material layer 30' before the heat treatment may be amorphous, and may be converted into the crystalline ferroelectric layer 30 having ferroelectric properties through a heat treatment process. As described above, the material layer 30' may be deposited by applying a thin-film deposition process, and in the thin-film deposition process, a carbon-containing metal precursor, that is, an organic metal precursor, may be applied. Accordingly, some unreacted carbon remaining inside the deposited thin film may act as a defect in a ferroelectric thin film and deteriorate electrical characteristics. In addition, the deposited ferroelectric thin film may have a certain amount of Vo therein.

According to an embodiment, the ferroelectric layer 30 having ferroelectric properties may be formed by crystallizing the deposited amorphous material layer 30' through heat treatment at a low temperature, for example, at a temperature of at least 200 °C but less than 500 °C, in a vacuum environment within, for example, a range of 1E-7 Torr to 9E-4 Torr. As such, when performing crystallization through a low-temperature heat treatment process in a vacuum environment, it may be seen from the sample of the embodiment on the right side of FIG. 6 that only a small amount of carbon remains in the ferroelectric layer 30, and oxygen vacancies also are reduced.

FIG. 7 shows a comparison between material layers 30a' and 30b' before heat treatments, and ferroelectric layers 30a and 30b after the heat treatments, according to a comparative example and an embodiment. For a stack structure of the conductive material layer 11a, the material layer 30', and the electrode layer 50a, an existing heat treatment method is applied to the sample of the comparative example, in which the ferroelectric layer 30a crystallized to have ferroelectric properties is formed by performing high-temperature heat treatment at about 500 °C through rapid thermal processing (RTP), whereas the sample of the embodiment is an example in which the ferroelectric layer 30b crystallized to have ferroelectric properties is formed by performing heat treatment at a relatively low temperature of about 250 °C in a vacuum environment of about 9E-5 Torr or less. The sample of the embodiment and the sample of the comparative example may have the stack structure formed under the same conditions, and only the heat treatment conditions may be different. For example, the sample of the embodiment and the sample of the comparative example may have the stack structure formed such as the conductive material layer 11a may include molybdenum (Mo) and may have a thickness of about 1000 Å, the material layer 30' may include HZO deposited by atomic layer deposition (ALD) and may have a thickness of about 70 Å, and the electrode layer 50a may include molybdenum (Mo) and may have a thickness of about 1200 Å. For example, for the stack structure as above, the sample of the comparative sample may be heat treated using a general rapid thermal processing (RTP), whereas the sample of the embodiment may be heat treated, for example, at a temperature of about 250°C for about 30 minutes in a vacuum of about 10⁻⁵ Torr.

Comparing the ferroelectric layers 30a and 30b crystallized after the heat treatments in the samples of the comparative example and the embodiment, the ferroelectric layer 30a of the sample of the comparative example has a carbon concentration greater than that of the ferroelectric layer 30b of the sample of the embodiment, thus has a high defect value, and may deteriorate in electrical characteristics. On the contrary, it may be seen that, in the ferroelectric layer 30b of the sample of the embodiment, as the concentration of remaining carbon is reduced, the electrical characteristics are improved, and as oxygen vacancies with a radius of about 66 pm, which were covered by carbon with a radius of about 69 pm, are reduced, the oxygen content increases.

As such, according to the process of manufacturing a ferroelectric thin film according to an embodiment and the electronic device 10 formed by applying the process, the ferroelectric layer 30 including HfₓA_{y}O_{z} (where 2(x+y) < z, 0 ≤ x ≤ 1, and 0 ≤ y ≤ 1) may be formed, and in this case, because oxygen vacancies (Vo) formed inside the ferroelectric layer 30 and carbon formed from ligands of a pyrolyzed precursor are reduced, electrical characteristics may be improved and reliability may be secured.

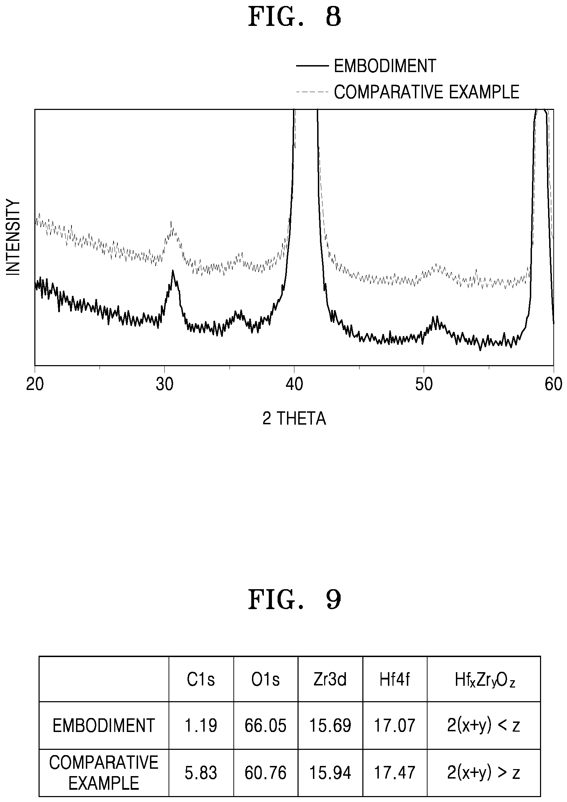

FIGS. 8 to 13 show comparisons between characteristics of the above-described samples of the embodiment and the comparative example.

FIGS. 8 and 9 show results of X-ray diffraction analysis and X-ray photoelectron spectroscopy (XPS) elemental analysis of the samples of the respective heat treatment methods.

Referring to FIG. 8, it may be seen that the sample of the embodiment obtained by performing a low-temperature heat treatment exhibits crystal properties similar to those of the sample of the comparative example obtained by performing a high-temperature heat treatment. From this, it may be confirmed that crystallinity of the sample of the embodiment is well secured even though the heat treatment temperature is about 1/2 times that of the sample of the comparative example.

In addition, referring to 'O1s' in FIG. 9 representing the oxygen content, it may be seen that the oxygen content of the sample of the embodiment is 66.05 and the oxygen content of the sample of the comparative example is 60.76, which indicates that the oxygen content of the sample of the embodiment is greater than that of the sample of the comparative example. As such, there is a difference in oxygen content between the sample of the embodiment and the comparative example. The sample of the embodiment may have the proportion of oxygen adjusted to include an excess of oxygen, and the comparative example sample has an oxygen deficiency compared to the sample of the embodiment.

In addition, referring to 'C1s' representing the content of residual carbon, it may be seen that the carbon content of the sample of the embodiment is 1.19, which is much less than 5.83 of the sample of the comparative example. In addition, it may be seen that the carbon content of the sample of embodiment is about 6.97 at% with respect to the Hf element, which is less than 33 at%. In addition, referring to 'HfₓZr_{y}O_{z'}, it may be confirmed that the sample of the embodiment satisfies the condition of 2(x + y) < z, and thus, the ferroelectric layer 30b is formed of oxygen-rich HZO. That is, it may be confirmed that the ferroelectric layer 30b is formed as an oxygen-excess ferroelectric thin film with HfₓZr_{y}O₂₊ₐ (where a is greater than 0 and less than 1, for example, greater than 0 but less than or equal to 0.5, or greater than 0 but less than or equal to 0.3). On the contrary, it may be seen that the ferroelectric layer 30a of the sample of the comparative example is formed to satisfy the condition of 2(x + y) > z.

As such, it may be confirmed that the concentrations of carbon and oxygen vacancies in the sample of the embodiment are less than those in a sample obtained by performing high temperature heat treatment as in the comparative example, and HfₓZr_{y}O_{z} satisfies 2(x + y) < z, which means that the concentration of oxygen vacancies is low.

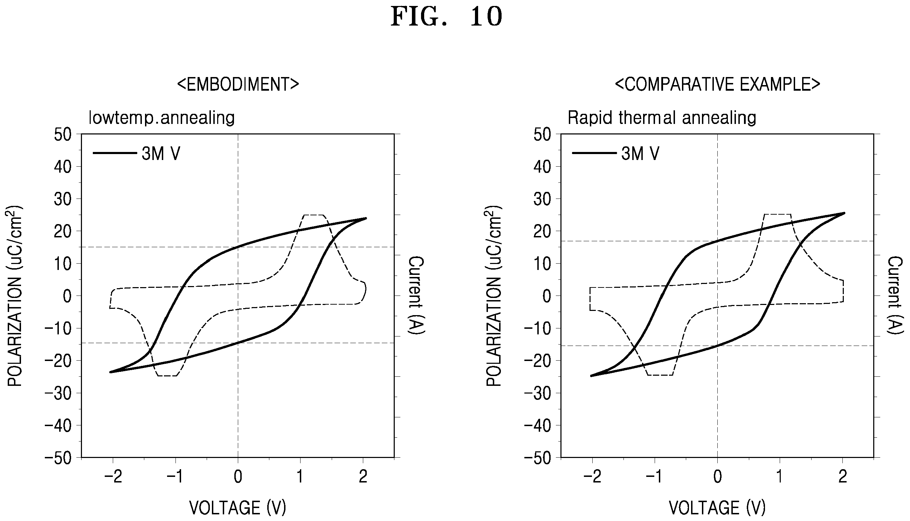

FIG. 10 shows ferroelectric (P-V) properties of the samples of the respective heat treatment methods. In the graphs respectively showing ferroelectric (P-V) properties of the sample of the embodiment and the sample of the comparative example in FIG. 10, the horizontal axis represents voltage, the left vertical axis represents polarization, and the right vertical axis represents current. It may be confirmed that, when P-V is measured at approximately 3 MV/cm (that is, 2.1V based on a thickness of about 7nm), the samples of the embodiment and the comparative example show similar properties, and the oxygen vacancy concentration of the sample of the embodiment is less than that of the sample of the comparative example, thus, the remnant polarization of the sample of the embodiment is less than that of the sample of the comparative example, and thus, the coercive field of the sample of the embodiment is larger than that of the sample of the comparative example.

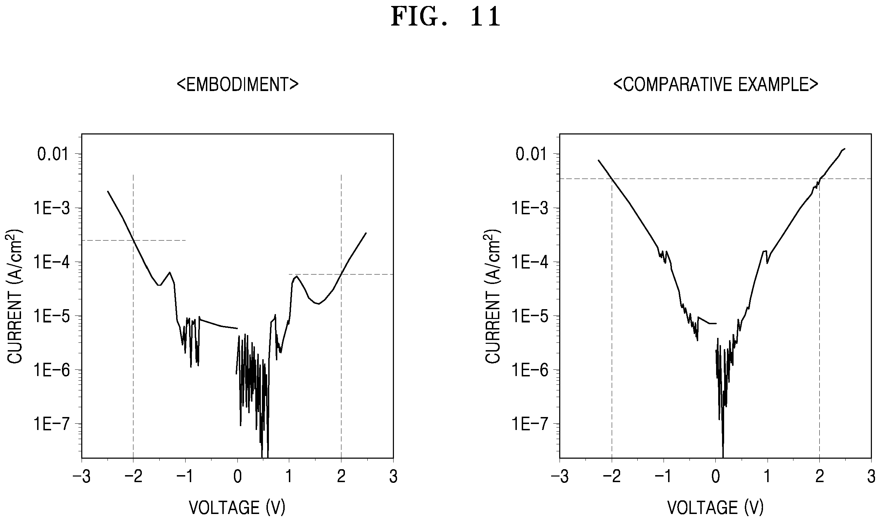

FIG. 11 shows leakage current (I-V) characteristics of the samples of the respective heat treatment methods. In the graphs, which respectively show the leakage current (I-V) characteristics of the sample of the embodiment and the sample of the comparative example in FIG. 11, the horizontal axis represents voltage and the vertical axis represents current. Referring to the leakage current characteristics of the samples of the embodiment and the comparative example, it may be seen that the leakage current characteristics of the sample of the embodiment are improved.

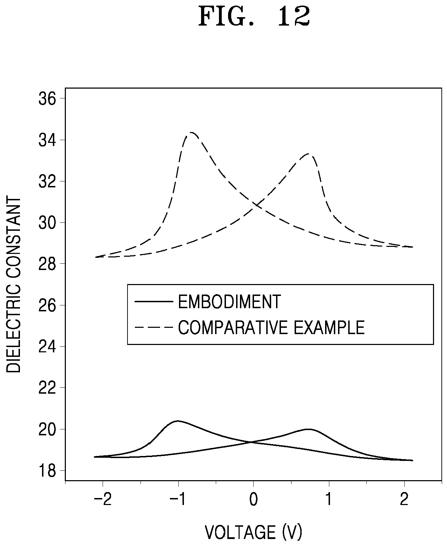

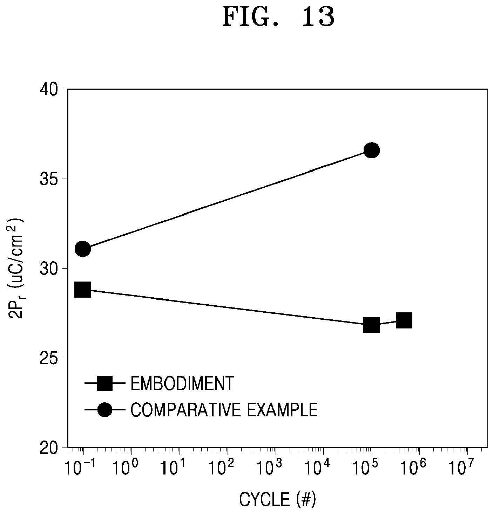

FIGS. 12 and 13 show capacitance-voltage characteristics and endurance characteristics of the samples of the respective heat treatment methods. The endurance characteristics of FIG. 13 are obtained by applying a voltage of 3 MV (2.1V) at a rate of 100kHz, checking P-V in 1 cycle (pristine), then cycling and checking once in 100,000 cycles (wore-up).

Referring to FIG. 12, in the sample of the embodiment, it may be seen that the dielectric constant (k) is within a range of approximately 15 to 25. From this, it may be seen that, in the electronic device according to an embodiment, the ferroelectric layer 30 may be formed to have a dielectric constant within the range of about 15 to about 25, and the difference in dielectric constant between the ferroelectric layer 30 and the dielectric layer 25 may be reduced, which may alleviate an electric field concentration phenomenon that causes reliability degradation.

Referring to FIG. 13, it may be confirmed that the 2Pr values of the samples of the embodiment and the comparative example are greater than or equal to 20 µC/cm², and the endurance characteristics of the sample of the embodiment are improved by about 1 order compared to the sample of the comparative example. From this, it may be seen that, in the electronic device according to an embodiment, the ferroelectric properties of the ferroelectric layer 30 may have a high switching voltage while having a minimum Pr value required in a memory device.

In the above, it is illustrated that the electronic device 10,100, 10a, or 100a according to an embodiment is a field-effect transistor having the planar channel 11, but the disclosure is not limited thereto. For example, the concept according to the above-described embodiment may be applied to a fin field-effect transistor (FinFET), a gate-all-around FET (GAAFET), or a multi-bridge channel FET (MBCFET) having a three-dimensional (3D) channel structure.

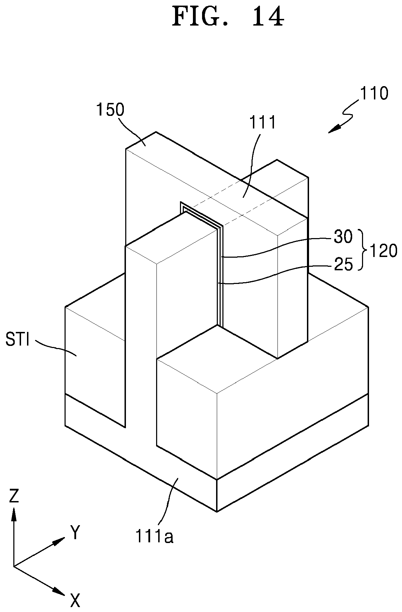

FIG. 14 illustrates an example in which an electronic device 110 is formed in a 3D structure including a fin channel 111, according to an embodiment.

Referring to FIG. 14, the electronic device 110 according to an embodiment may be provided to have the fin channel 111 that protrudes in a Z-direction from the upper surface of a substrate 111a and extends in a Y-direction. A first source/drain region and a second source/drain region protruding in the Z-direction from the upper surface of the substrate 111a may be provided on both sides of the fin channel 111. In other words, a first end of the channel 111 may be in contact with the first source/drain region and a second end of the channel 111 may be in contact with the second source/drain region. The channel 111 may include, for example, a relatively lightly doped p-type semiconductor or a relatively lightly doped n-type semiconductor.

In addition, for example, a shallow trench insulator (STI) may be formed for electrical separation from adjacent devices (not shown) and to form a gate electrode 150 surrounding the channel 111. The STI may be formed by forming a shallow trench around the channel 111 or a region corresponding to the channel 111 and filling the trench with an insulating material. The gate electrode 150 may be formed on the STI to surround the channel 111. A gate insulating layer 120 may be provided between the channel 111 and the gate electrode 150. For example, the electronic device 110 having a fin channel structure may be formed by forming the gate insulating layer 120 to surround the channel 111 and forming the gate electrode 150 to surround the gate insulating layer 120. The electronic device 110 illustrated in FIG. 14 may be, for example, a FinFET.

As in the electronic devices 10 and 100 described above with reference to FIGS. 1 and 3, in the electronic device 110 according to an embodiment, the gate insulating layer 120 may include the ferroelectric layer 30 and the dielectric layer 25, or may include only the ferroelectric layer 30. In addition, as in the electronic devices 10a and 100a described above with reference to FIGS. 4 and 5, in the electronic device 110 according to an embodiment, the gate insulating layer 120 may further include the perovskite layer 35. FIG. 14 illustrates an example in which the gate insulating layer 120 includes the ferroelectric layer 30 and the dielectric layer 25.

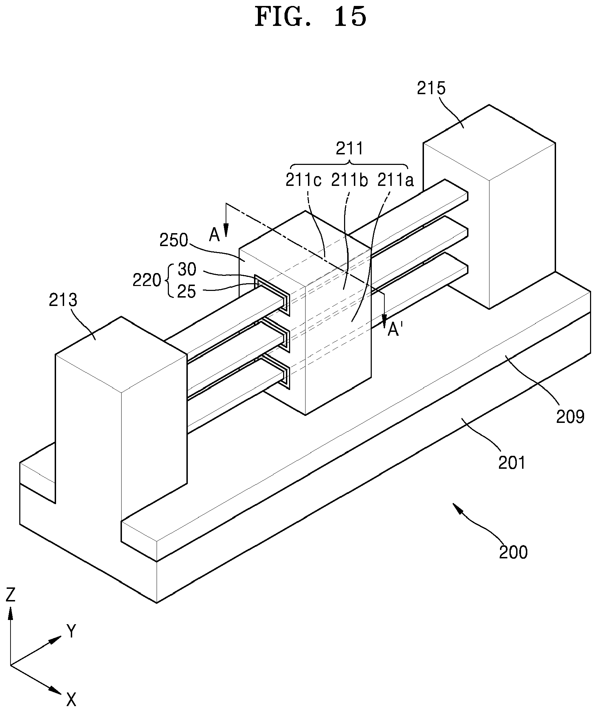

FIG. 15 illustrates an example in which an electronic device 200 is formed in a 3D structure in which a gate electrode 250 surrounds a channel 211 in all directions, according to an embodiment.

Referring to FIG. 15, the electronic device 200 may include a substrate 201, a first source/drain region 213 protruding in the Z-direction from the upper surface of the substrate 201, an isolation layer 209, a second source/drain region 215 protruding in the Z-direction from the upper surface of the substrate 201, the channel 211 having a bar shape extending in the Y-direction and spaced apart from the upper surface of the substrate 201, a gate insulating layer 220 surrounding and covering the channel 211, and the gate electrode 250 surrounding and covering the gate insulating layer 220. The channel 211 may extend in the Y-direction and be connected between the first source/drain region 213 and the second source/drain region 215. In other words, a first end of the channel 211 may be in contact with the first source/drain region 213 and a second end of the channel 211 may be in contact with the second source/drain region 215. The channel 211 may include a relatively lightly doped p-type semiconductor or a relatively lightly doped n-type semiconductor. The channel 211 may include a plurality of channel elements 211a, 211b, and 211c arranged at intervals therebetween in the Z-direction or an X-direction different from the Y-direction. Although FIG. 15 illustrates that three channel elements 211a, 211b, and 211c are arranged in the Z-direction at intervals, this is merely an example and the disclosure is not limited thereto. The electronic device 200 illustrated in FIG. 15 may be, for example, a GAAFET or an NMCFET. The isolation layer 209 may include an insulating material, such as silicon oxide. The first source/drain region 213 and the second source/drain region 215 may protrude through the isolation layer 209.

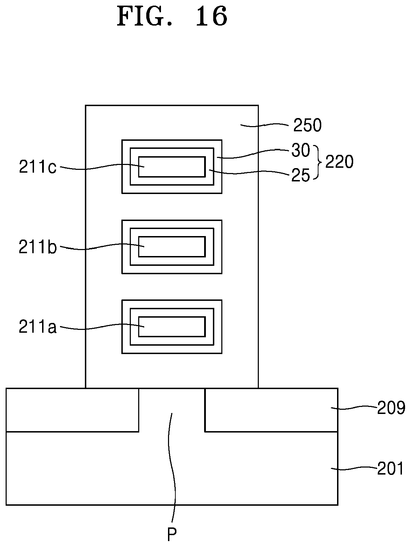

FIG. 16 is a cross-sectional view schematically illustrating a gate structure of the electronic device 200 illustrated in FIG. 15, and in particular, schematically illustrates a cross-section of the gate structure taken along line A-A'.

Referring to FIG. 16, the electronic device 200 may include a plurality of gate insulating layers 220 arranged to surround four surfaces of the plurality of channel elements 211a, 211b, and 211c, respectively. As in the electronic devices 10 and 100 described above with reference to FIGS. 1 and 3, the gate insulating layer 220 may include the ferroelectric layer 30 and the dielectric layer 25, or may include only the ferroelectric layer 30. In addition, as in the electronic devices 10a and 100a described above with reference to FIGS. 4 and 5, the gate insulating layer 220 may further include the perovskite layer 35. FIGS. 15 and 16 illustrate an example in which the gate insulating layer 220 includes the dielectric layer 25 and the ferroelectric layer 30, and the dielectric layer 25 and the ferroelectric layer 30 are arranged to surround four surfaces of the channel elements 211a, 211b, and 211c. Meanwhile, the gate electrode 250 may have a structure extending in the Z-direction and protruding from the upper surface of the substrate 201 so as to surround four surfaces of the gate insulating layer 220. The substrate 201 may include a portion P that protrudes through the isolation layer 209. A level of an upper surface of the portion P may be level with an upper surface of the isolation layer 209, but example embodiments are not limited thereto. The gate electrode 250 may be on the upper surface of the portion P and a part of the upper surface of the isolation layer 209.

The electronic devices 10, 10', 100, 10a, 100a, 110, and 200 described above may be employed in various electronic apparatuses. For example, the electronic devices 10, 10', 100, 10a, 100a, 110, and 200 described above may be used as logic transistors or memory transistors. In addition, the electronic devices 10, 10', 100, 10a, 100a, 110, and 200 described above may be utilized as memory cells, and may constitute a memory cell array in which a plurality of memory cells are arranged two-dimensionally, arranged in one vertical or horizontal direction, or arranged in one direction to form a memory cell string and a plurality of memory cell strings are two-dimensionally arranged. In addition, the above-described electronic devices may constitute part of an electronic circuit constituting an electronic apparatus together with other circuit elements such as capacitors.

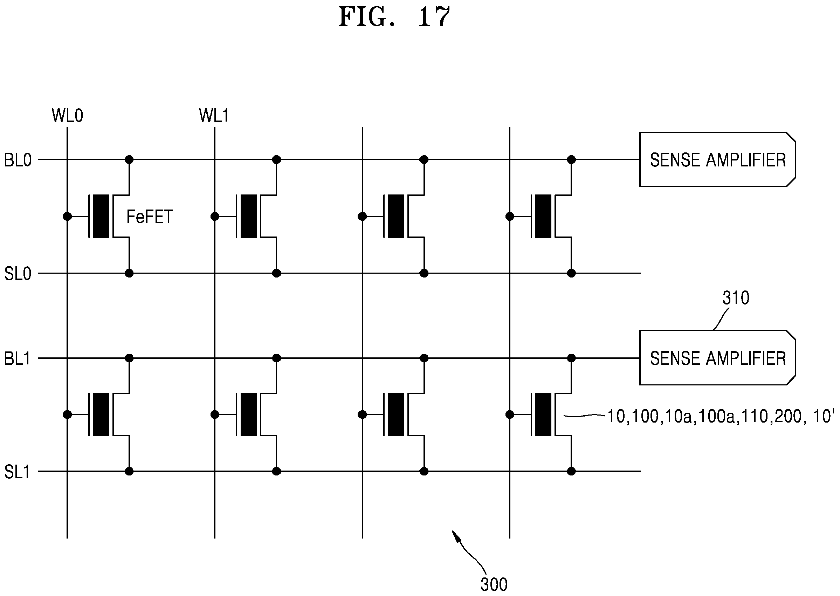

FIG. 17 is a schematic circuit diagram of a memory device including an electronic device array. Referring to FIG. 17, a memory device 300 may include an array of a plurality of electronic devices 10, 10', 100, 10a, 100a, 110, or 200 that are two-dimensionally arranged. In addition, the memory device 300 may include a plurality of bit lines BL0 and BL1, a plurality of select lines SL0 and SL1, and a plurality of word lines WL0 and WL1. The select lines SL0 and SL1 may be electrically connected to first source/drain regions of the electronic devices 10, 10', 100, 10a, 100a, 110, or 200, the bit lines BL0 and BL1 may be electrically connected to second source/drain regions of the electronic devices 10, 10', 100, 10a, 100a, 110, or 200, and the plurality of word lines WL0 and WL1 may be electrically connected to gate electrodes of the electronic devices 10, 10', 100, 10a, 100a, 110, or 200. In addition, the memory device 300 may further include an amplifier 310 for amplifying signals output from the bit lines BL0 and BL1. Each of the electronic devices 10, 10', 100, 10a, 100a, 110, or 200 may be one memory cell of the memory device 300.

Although illustrated as a two-dimensional plane in FIG. 17 for convenience, the memory device 300 may have a stack structure of two or more stages. For example, the plurality of bit lines BL0 and BL1 and the plurality of select lines SL0 and SL1 extending in a vertical direction may be two-dimensionally arranged, and the plurality of word lines WL0 and WL1 extending in a horizontal direction may be respectively arranged in a plurality of layers. However, the disclosure is not limited thereto, and memory cells may be three-dimensionally arranged in various manners.

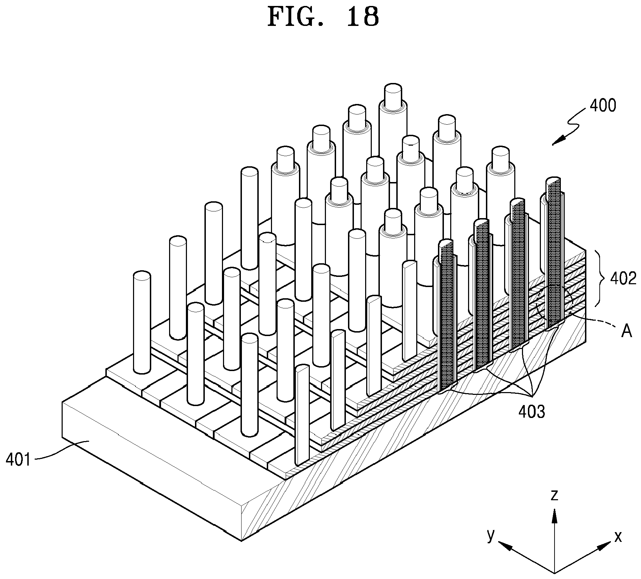

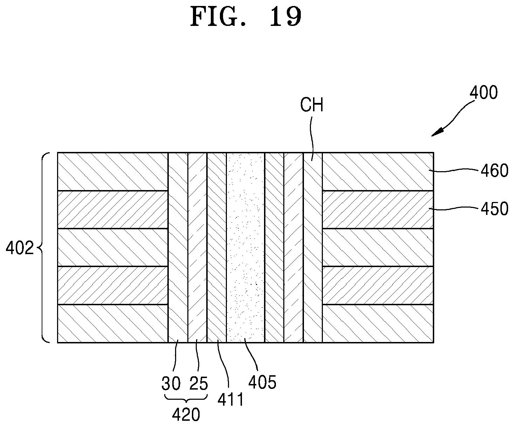

FIG. 18 is a perspective view illustrating an electronic device 400 according to an embodiment, and FIG. 19 is an enlarged cross-sectional view of portion A of FIG. 18. The electronic device 400 illustrated in FIG. 18 may be a memory cell string of a three-dimensional (or vertical) NAND (e.g., VNAND) or three-dimensional FeFET memory.

Referring to FIG. 18, the electronic device 400 may include a stack structure 402 in which a plurality of insulating layers 460 and a plurality of gate electrodes 450 are alternately and repeatedly stacked, a plurality of channel holes (see CH in FIG. 19) may be formed to penetrate the stack structure 402, and a gate insulating layer 420, a channel 411, and a dielectric filler 405 may be arranged concentrically inside the channel hole CH to form a memory cell string, and a plurality of memory cell strings may be two-dimensionally arranged.

As in the electronic devices 10 and 100 described above with reference to FIGS. 1 and 3, the gate insulating layer 420 may include the ferroelectric layer 30 and the dielectric layer 25, or may include only the ferroelectric layer 30. In addition, as in the electronic devices 10a and 100a described above with reference to FIGS. 4 and 5, the gate insulating layer 420 may further include the perovskite layer 35. FIGS. 18 and 19 illustrate an example in which the gate insulating layer 420 includes the dielectric layer 25 and the ferroelectric layer 30.

In detail, the plurality of insulating layers 460 and the plurality of gate electrodes 450 each extend along an X-Y plane on a substrate 401 and are alternately and repeatedly stacked in the Z-direction to form the stack structure 402. In addition, the electronic device 400 may include a cell string 403 including the gate insulating layer 420 including the ferroelectric layer 30 and the dielectric layer 25, the channel 411 and the dielectric filler 405, and the cell string 403 may be arranged to penetrate the stack structure 402. In other words, the insulating layers 460 and the gate electrodes 450 may be arranged to surround the periphery of the cell string 403. In detail, the gate insulating layer 420 including the ferroelectric layer 30 and the dielectric layer 25, the channel 411, and the dielectric filler 405 may all extend in the Z-direction to intersect with the insulating layers 460 and the gate electrodes 450.

In addition, the dielectric filler 405 may be arranged at a central portion of the cell string 403, and the gate insulating layer 420 including the ferroelectric layer 30 and the dielectric layer 25, and the channel 411 may be arranged to concentrically surround the dielectric filler 405. The dielectric layer 25 may be arranged between the ferroelectric layer 30 and the channel 411. The electronic device 400 may include a plurality of cell strings 403, and the cell strings 403 may be two-dimensionally arranged on an X-Y plane to be spaced apart from each other.

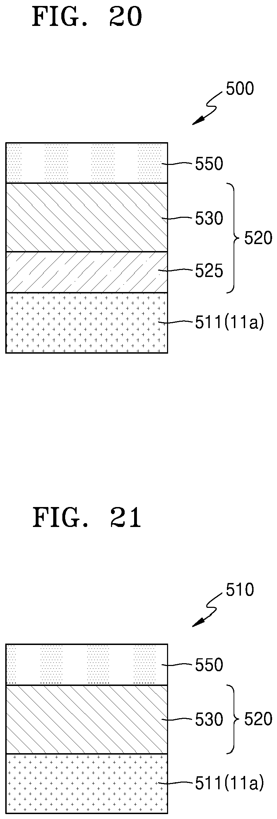

As another example, as illustrated in FIGS. 20 and 21, an electronic device 500 or 510 according to an embodiment may include another electrode layer 511 as the conductive material layer 11a so as to be implemented as a capacitor. In addition, the electronic device 500 or 510 according to an embodiment may be implemented as a capacitor and may be a partial component of an electronic circuit implemented as an integrated device.

FIGS. 20 and 21 are cross-sectional views schematically illustrating the electronic devices 500 and 510 according to an embodiment.

Referring to FIGS. 20 and 21, the electronic device 500 or 510 according to an embodiment includes an electrode layer 550, an electrode layer 511 spaced apart from the electrode layer 550, and an insulating layer 520 arranged between the electrode layer 550 and the electrode layer 511. The electrode layer 511 corresponds to the conductive material layer 11a. The insulating layer 520 includes a ferroelectric layer 530 covering the electrode layer 511 and may further include a dielectric layer 525. FIG. 20 illustrates an example in which the insulating layer 520 includes the dielectric layer 525 between the electrode layer 511 and the ferroelectric layer 530. FIG. 21 illustrates an example in which the insulating layer 520 includes only the ferroelectric layer 530. The electronic device 500 or 510 according to an embodiment may be provided to expand a negative capacitance region and may be implemented as a capacitor or a ferroelectric memory.

The electrode layer 550 and the electrode layer 511 may include a conductive material. For example, the electrode layer 550 and the electrode layer 511 may include a metal and an alloy thereof, a metal nitride, a metal carbide, a metal oxide, a two-dimensional conductive material, or a combination thereof. For example, the metal may include at least one of aluminum (Al), tungsten (W), molybdenum (Mo), titanium (Ti), tantalum (Ta), chromium (Cr), and copper (Cu), or an alloy thereof. The metal nitride may include, for example, titanium nitride (TiN), tantalum nitride (TaN), or the like. The metal carbide may include a metal carbide doped with (or containing) at least one of aluminum and silicon, for example, TiAlC, TaAlC, TiSiC, or TaSiC. The metal oxide may include, for example, indium oxide (In2O3), tin oxide (SnO2), zinc oxide (ZnO), indium oxide-tin oxide alloy (In2O3-SnO2: ITO), indium oxide-zinc oxide alloy (In2O3-ZnO), or the like. At least one of the electrode layer 550 and the electrode layer 511 may include a plurality of layers, and may have, for example, a stack structure of metal nitride layer/metal layer or a stack structure of metal nitride layer/metal carbide layer/metal layer.

The ferroelectric layer 530 may correspond to the ferroelectric layer 30 described above with reference to FIGS. 1 and 3, and may cover the electrode layer 511. Like the ferroelectric layer 30 described above, the ferroelectric layer 530 may be formed to include HfₓA_{y}O_{z} (where 2(x+y) < z, 0 ≤ x ≤ 1, and 0 ≤ y ≤ 1). For example, the ferroelectric layer 530 may be formed to include HfₓZr_{y}O₂ (where 2(x+y) < 2). The description of the ferroelectric layer 30 provided above is applied to the ferroelectric layer 530, and redundant descriptions will be omitted.

The dielectric layer 525 may be formed of, for example, a dielectric material that is not ferroelectric. For example, the dielectric layer 525 may include an amorphous or antiferroelectric dielectric material. The dielectric layer 525 may correspond to the dielectric layer 25 described above with reference to FIG. 1, and may include, for example, at least one of SiO, AlO, SiON, and SiN. The dielectric layer 525 may include a plurality of layers having different dielectric constants. The description of the dielectric layer 25 provided above is applied to the dielectric layer 525, and redundant descriptions will be omitted.

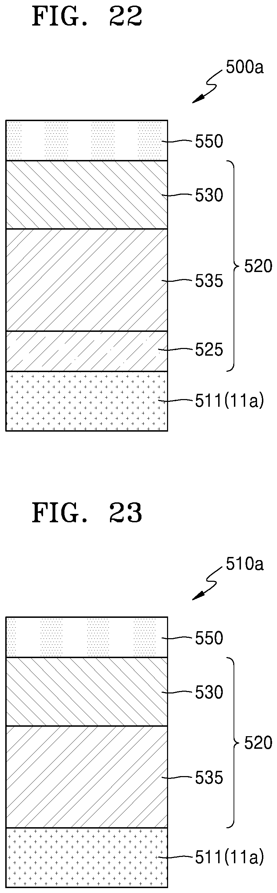

FIG. 22 is a cross-sectional view schematically illustrating an electronic device 500a according to an embodiment, and the electronic device 500a is substantially the same as the electronic device 500 according to the embodiment of FIG. 20, except that the electronic device 500a further includes a ferroelectric perovskite layer 535 between the dielectric layer 525 and the ferroelectric layer 530. FIG. 23 is a cross-sectional view schematically illustrating an electronic device 510a according to an embodiment, and the electronic device 510a is substantially the same as the electronic device 510 according to the embodiment of FIG. 21, except that the electronic device 510a further includes the ferroelectric perovskite layer 535 between the electrode layer 511 and the ferroelectric layer 530. As illustrated in FIGS. 22 and 23, the insulating layer 520 may further include the perovskite layer 535. The description of the perovskite layer 35 provided above is applied to the perovskite layer 535, and redundant descriptions will be omitted.

The electronic device 500, 510, 500a, or 510a according to an embodiment may also be implemented as a capacitor or a ferroelectric memory.

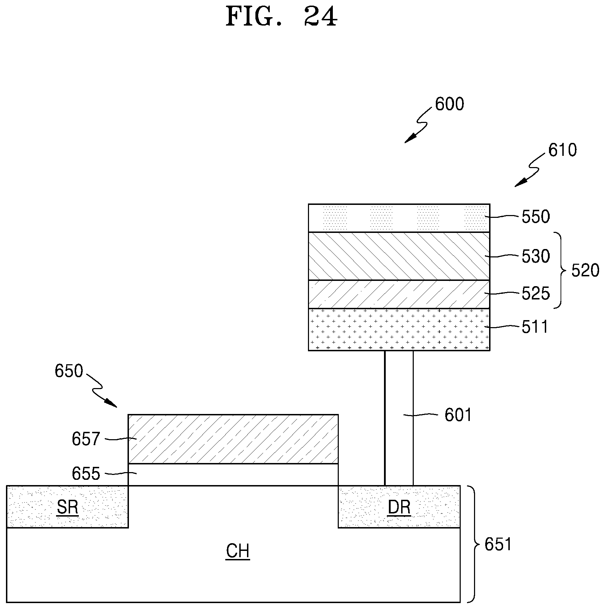

FIG. 24 schematically illustrates an example of applying an electronic device according to an embodiment.

Referring to FIG. 24, an electronic device 600 may include a structure in which a capacitor 610 and a transistor 650 are electrically connected to each other, and may be a partial component of an electronic circuit implemented as an integrated device.

As the capacitor 610, the electronic devices 500, 510, 500a, or 510a of FIGS. 20 to 23 may be used. The capacitor 610 may have, for example, a stack structure of the electrode layer 511, the insulating layer 520, and the electrode layer 550, and the insulating layer 520 may include the dielectric layer 525 and the ferroelectric layer 530, may include only the ferroelectric layer 530, may include the dielectric layer 525, the perovskite layer 535, and the ferroelectric layer 530, or may include the perovskite layer 535 and the ferroelectric layer 530. FIG. 24 illustrates an example in which the electronic device 500 of FIG. 20 is used as the capacitor 610.

The capacitor 610 may be electrically connected to the transistor 650 through a contact 601. The transistor 650 may be a field-effect transistor. One of the electrodes 511 and 550 of the capacitor 610 may be electrically connected to one of a source SR and a drain DR of the transistor 650 through the contact 601.

The transistor 650 may include a semiconductor substrate 651 including the source SR, the drain DR, and a channel CH, and a gate electrode 657 arranged to face the channel CH, and may include a gate insulating layer 655 arranged between the channel CH and the gate electrode 657.

The semiconductor substrate 651 may include a semiconductor material. The semiconductor substrate 651 may include the source SR, the drain DR, and the channel CH electrically connected to the source SR and the drain DR. The source SR may be electrically connected to or in contact with one end of the channel CH, and the drain DR may be electrically connected to or in contact with the other end of the channel CH. In other words, the channel CH may be defined as a substrate region between the source SR and the drain DR in the semiconductor substrate 651.

The source SR, the drain DR, and the channel CH may be independently formed by injecting impurities into different regions of the semiconductor substrate 651, and in this case, the source SR, the channel CH, and the drain DR may include a substrate material as a base material. In addition, the source SR and the drain DR may be formed of a conductive material. The channel CH may not be formed as a substrate base, but may be implemented as a separate material layer.

The gate electrode 657 may be arranged on the semiconductor substrate 651 to be spaced apart from the semiconductor substrate 651 and face the channel CH.

The gate insulating layer 655 arranged between the semiconductor substrate 651 and the gate electrode 657 may include a paraelectric material or a high-k material. The gate insulating layer 655 and the gate electrode 657 may constitute a gate stack.

As the transistor 650, the electronic device 10, 10', 100, 10a, or 100a according to an embodiment described above with reference to FIGS. 1, 3, 4, and 5 may be used. In addition, the transistor 650 may have various channel structures as in the electronic devices 110 and 200 described above with reference to FIGS. 14 to 16.

The contact 601 may include any suitable conductive material, for example, tungsten, copper, aluminum, polysilicon, or the like.

The arrangement of the capacitor 610 and the transistor 650 may be variously modified. For example, the capacitor 610 may be arranged on the semiconductor substrate 651 as illustrated, or may be buried in the semiconductor substrate 651.

Although FIG. 24 illustrates the electronic device 600 having one capacitor 610 and one transistor 650, the electronic device 600 may have a structure in which capacitors 610 and transistors 650 are two-dimensionally and repeatedly arranged.

In the electronic device according to the various embodiments described above and an electronic apparatus to which the electronic device is applied, thin film deposition may be performed by using various deposition methods such as ALD, metal organic ALD (MOALD), CVD, metal organic CVD (MOCVD), or PVD. In addition, doping may be performed by using methods such as light ion implant, plasma treatment, or annealing under specific atmosphere, in addition to the above deposition methods.

According to the electronic device according to various embodiments described above, the amount of oxygen vacancies (Vo) formed inside a ferroelectric layer and carbon formed from ligands of a pyrolyzed precursor are reduced, and thus, electrical characteristics may be improved and reliability may be secured. In addition, for example, the electronic device may have a minimum remnant polarization (Pr) value required in a ferroelectric memory device while having a high switching voltage, and as the difference from the dielectric constant of an interfacial layer below a ferroelectric layer, that is, a dielectric layer that is not ferroelectric, is reduced, an electric field concentration phenomenon that causes reliability degradation may be alleviated. In addition, the electronic device according to various embodiments described above may have a metal-oxide-semiconductor capacitor (MOSCAP) structure or a capacitor structure by stacking a ferroelectric layer and a dielectric layer, may be used as a gate stack when applied to a field-effect transistor (FET), and may be applied to a 3D structure as well as a 2D structure.

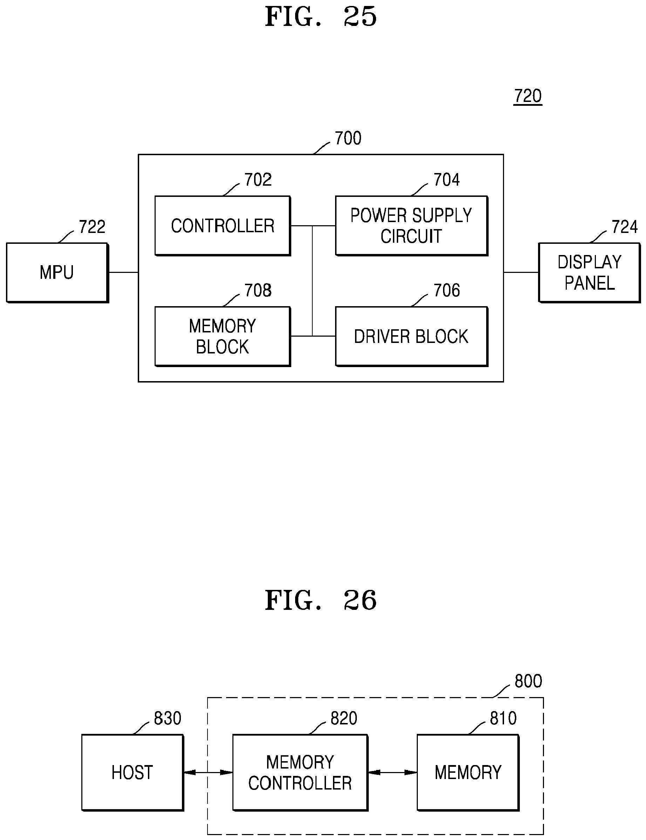

FIG. 25 is a schematic block diagram of a display driver integrated circuit (IC) (DDI) 700 and a display apparatus 720 including the DDI 700, according to an embodiment.

Referring to FIG. 25, the DDI 700 may include a controller 702, a power supply circuit 704, a driver block 706, and a memory block 708. The controller 702 may receive and decode a command applied from a main processing unit (MPU) 722, and control each block of the DDI 700 to implement an operation according to the command. The power supply circuit 704 generates a drive voltage in response to control of the controller 702. The driver block 706 drives a display panel 724 by using the drive voltage generated by the power supply circuit 704 in response to control of the controller 702. The display panel 724 may be, for example, a liquid-crystal display panel, an organic light-emitting device (OLED) display panel, a microlight emitting device (microLED) panel, or a plasma display panel. The memory block 708 may temporarily store a command input to the controller 702 or control signals output from the controller 702, or may store necessary data, and may include memory such as random-access memory (RAM) or read-only memory (ROM). For example, the memory block 708 may include electronic devices according to the above-described embodiments.

FIG. 26 is a block diagram illustrating an electronic apparatus 800 according to an embodiment. Referring to FIG. 26, the electronic apparatus 800 includes a memory 810 and a memory controller 820. The memory controller 820 may control the memory 810 to read data from the memory 810 and/or write data to the memory 810 in response to a request from a host 830. The memory 810 may include electronic devices according to the above-described embodiments.

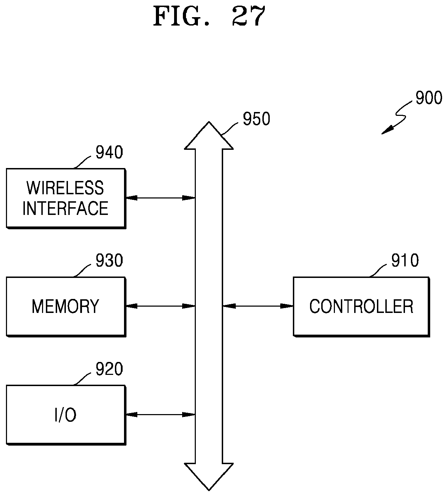

FIG. 27 is a block diagram of an electronic apparatus 900 according to an embodiment. Referring to FIG. 27, the electronic apparatus 900 may constitute a wireless communication device or a device capable of transmitting and/or receiving information in a wireless environment. The electronic apparatus 900 includes a controller 910, an input/output device (I/O) 920, a memory 930, and a wireless interface 940, which are connected to each other through a bus 950.

The controller 910 may include at least one of a microprocessor, a digital signal processor, or a processing device similar thereto. The input/output device 920 may include at least one of a keypad, a keyboard, or a display. The memory 930 may be used to store a command executed by controller 910. For example, the memory 930 may be used to store user data. The electronic apparatus 900 may use the wireless interface 940 to transmit/receive data through a wireless communication network. The wireless interface 940 may include an antenna and/or a wireless transceiver. In some embodiments, the electronic apparatus 900 may be used for a third generation communication system, for example, code-division multiple access (CDMA), global system for mobile communications (GSM), north American digital cellular (NADC), extended-time division multiple access (E-TDMA), and/or a communication interface protocol for the third generation communication system, for example, wide-band CDMA (WCDMA). The memory 930 of the electronic apparatus 900 may include an electronic device according to the above-described embodiments.

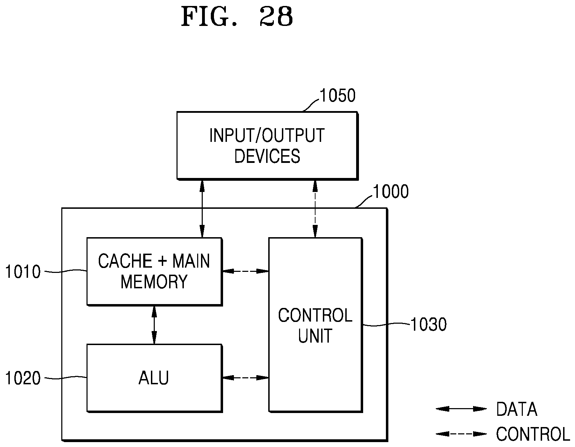

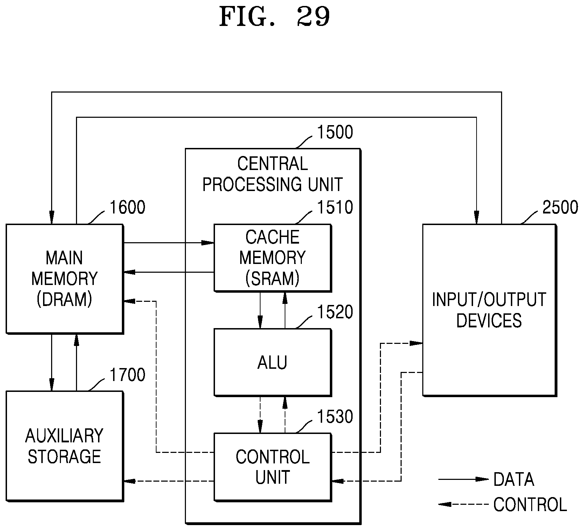

FIGS. 28 and 29 are conceptual diagrams schematically illustrating a device architecture that may be applied to an electronic apparatus, according to an embodiment.

Referring to FIG. 28, an electronic device architecture 1000 may include a memory unit 1010 and a control unit 1030, and may further include an arithmetic logic unit (ALU) 1020. The memory unit 1010, the ALU 1020, and the control unit 1030 may be electrically connected to each other. For example, the electronic device architecture 1000 may be implemented as one chip including the memory unit 1010, the ALU 1020, and the control unit 1030. In detail, the memory unit 1010, the ALU 1020, and the control unit 1030 may be connected to each other via metal lines in an on-chip manner, to directly communicate with each other. The memory unit 1010, the ALU 1020, and the control unit 1030 may be monolithically integrated on one substrate to constitute one chip. Input/output devices 1050 (e.g., keypad, keyboard, mouse, display) may be connected to the electronic device architecture (chip) 1000. In addition, the memory unit 1010 may include both a main memory and a cache memory. The electronic device architecture (chip) 1000 may be an on-chip memory processing unit. The memory unit 1010, the ALU 1020, and/or the control unit 1030 may independently include the electronic device according to the above-described embodiments.

Referring to FIG. 29, a cache memory 1510, an ALU 1520, and a control unit 1530 may constitute a central processing unit (CPU) 1500, and the cache memory 1510 may include static RAM (SRAM). Separate from the CPU 1500, a main memory 1600 and an auxiliary storage 1700 may be provided, and input/output devices 2500 may also be provided. The main memory 1600 may be, for example, dynamic RAM (DRAM) and may include the electronic device according to the above-described embodiments.

In some cases, the electronic device architecture may be implemented in such a manner that computing unit devices and memory unit devices are adjacent to each other in one chip without distinguishing sub-units.

Although the electronic device and the electronic apparatus including the electronic device are described above with reference to the embodiments illustrated in the drawings, the embodiments are merely examples, and it will be understood by one of skill in the art that various modifications and equivalent embodiments may be made therefrom. Therefore, the disclosed embodiments are to be considered in a descriptive sense only, and not for purposes of limitation. The scope of the disclosure is in the claims rather than the above descriptions, and all differences within the equivalent scope should be construed as being included in the disclosure.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

According to an electronic device including a ferroelectric thin film, and a method of manufacturing the electronic device according to an embodiment, a ferroelectric layer is formed through heat treatment at a relatively low temperature in a vacuum environment for conversion into a crystal exhibiting ferroelectric properties, thus, the amounts of oxygen vacancies (Vo) formed inside the ferroelectric layer and carbon formed from ligands of a pyrolyzed precursor are reduced, and accordingly, electrical characteristics may be improved and reliability may be secured.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An electronic device comprising:
a conductive material layer;
a ferroelectric layer covering the conductive material layer, the ferroelectric layer including a compound represented by HfₓA_{y}O_{z}, where 0 ≤ x ≤ 1, 0 ≤ y ≤ 1), and 2(x+y) < z; and
an electrode layer covering the ferroelectric layer.

2. The electronic device of claim 1, wherein
in the compound represented by HfₓA_{y}O_{z}, A comprises at least one of Al, Si, Zr, Y, La, Gd, Sr, and Mg.

3. The electronic device of claims 1 or 2, wherein
A is Zr so the compound represented by HfₓA_{y}O_{z} is a compound represented by HfₓZr_{y}O₂₊ₐ, where 2(x+y) < 2+a and 0 < a < 1.

4. The electronic device of any of claims 1-3, wherein
the ferroelectric layer further comprises carbon, and
a content of the carbon is less than 33 at% with respect to an amount of Hf in the ferroelectric layer.

5. The electronic device of any of claims 1-4, wherein
the ferroelectric layer further comprises carbon, and
a content of the carbon is less than 10 at% with respect to an amount of Hf in the ferroelectric layer.

6. The electronic device of any of claims 1-5, wherein
the ferroelectric layer further comprises carbon, and
a content of the carbon is less than 6 at% with respect to a sum of amounts of Hf, A, and O in the ferroelectric layer.

7. The electronic device of any of claims 1-6, wherein a thickness of the ferroelectric layer is 0.1 nm to 20 nm; and/or
wherein the ferroelectric layer is formed such that 2Pr is 10 µC/cm² or greater; and/or
wherein the ferroelectric layer has a dielectric constant in a range of 15 to 25.

8. The electronic device of any of claims 1-7, further comprising:
a dielectric layer, wherein
the dielectric layer is between the conductive material layer and the ferroelectric layer, between the ferroelectric layer and the electrode layer, or between the conductive material layer and the ferroelectric layer and between the ferroelectric layer and the electrode layer.

9. The electronic device of any of claims 1-8, wherein
the conductive material layer comprises a channel, and
the electrode layer comprises a gate electrode.

10. The electronic device of claim 9, further comprising:
a substrate, wherein
the channel is spaced apart from an upper surface of the substrate and the channel extends in a first direction, or
the channel includes a plurality of channel elements and the plurality of channel elements are spaced apart from each other in a second direction, the second direction being different from the first direction;
preferably wherein
the ferroelectric layer comprises a plurality of ferroelectric layers surrounding the plurality of channel elements, respectively, and
the gate electrode protrudes from the upper surface of the substrate and surrounds the plurality of ferroelectric layers.

11. The electronic device of claims 9 or 10, wherein
the gate electrode is one of a plurality of gate electrodes in a stack structure,
the stack structure includes the plurality of gate electrodes alternatively stacked with a plurality of insulating layers in a vertical direction,
the stack structure includes a plurality of channel holes penetrating the stack structure in the vertical direction, and
the ferroelectric layer and the conductive material layer are concentrically arranged inside the plurality of channel holes to form a memory cell string in which a plurality of memory cell strings are two-dimensionally arranged.

12. A semiconductor device comprising the electronic device of any of claims 1-11, wherein
the conductive material layer forms a channel;
the electrode layer is a gate electrode; and
wherein the semiconductor device further comprises a source region and a drain region electrically connected to both ends of the channel.

13. A method of manufacturing a ferroelectric thin film, the method comprising:
forming a material layer comprising Hf, A, and O, on a base layer; and
crystallizing the material layer by performing heat treatment on the material layer in a vacuum environment to provide a crystallized ferroelectric layer, the crystallized ferroelectric layer comprising a compound represented by HfₓA_{y}O_{z}, where 0 ≤ x ≤ 1, 0 ≤ y ≤ 1 and having an oxygen content of 2(x+y) < z.

14. The method of claim 13, further comprising:
forming an electrode layer on the material layer or the ferroelectric layer, wherein
the heat treatment is performed before the forming the electrode layer, the heat treatment is performed after the forming the electrode layer, or the heat treatment is performed before and after the forming the electrode layer;
preferably wherein the heat treatment is performed at a temperature of at least 200 °C but less than 500 °C, the heat treatment is performed in a vacuum environment with a pressure ranging from 1E-7 Torr to 9E-4 Torr, the heat treatment is performed at the temperature of 200 °C to 500 °C and in the vacuum environment with the pressure ranging from 1E-7 Torr to 9E-4 Torr;
preferably wherein the heat treatment is performed at a temperature of 200 °C to 350 °C.

15. The method of claims 13 or 14, wherein the heat treatment is performed in a chamber in which the material layer is formed.
